# EUROPÄISCHE PATENTSCHRIFT

(11) **EP 1 485 607 B1**
(45) Veröffentlichungstag und Bekanntmachung des Hinweises auf die Patenterteilung: **26.10.2005**
(21) Anmeldenummer: 03739431.9
(22) Anmeldetag: 12.02.2003
(51) Int. Cl.: F02M 51/00, F02M 55/00

(54) **DICHTUNGSELEMENT FÜR DEN PIEZOAKTOR EINES KRAFTSTOFF-EINSPRITZVENTILS**
SEALING ELEMENT FOR THE PIEZO ACTUATOR OF A FUEL INJECTION VALVE
ELEMENT D'ETANCHEITE POUR L'ACTIONNEUR PIEZOELECTRIQUE D'UNE SOUPAPE D'INJECTION DE CARBURANT

(30) Priorität: 13.02.2002 DE 10205909
(43) Veröffentlichungstag der Anmeldung: 15.12.2004
(73) Patentinhaber: SIEMENS AKTIENGESELLSCHAFT, 80333 München (DE)
(72) Erfinder: SCHÜRZ, Willibald, 93188 Pielenhofen (DE); SIMMET, Martin, 93051 Regensburg (DE); UNRUH, Marcus, 93197 Zeitlarn (DE)
(86) Internationale Anmeldenummer: PCT/DE2003/000409
(87) Internationale Veröffentlichungsnummer: WO 2003/069152

(56) Entgegenhaltungen:
- EP-A- 1 130 249
- DE-A- 10 045 706
- DE-C- 19 844 742
- DE-C- 19 844 743
- US-A- 5 797 761

## Beschreibung

Die Erfindung betrifft ein Dichtungselement, welches auf die Kopfplatte eines Piezoaktors für das Kraftstoff-Einspritzventil eines Verbrennungsmotors aufsteckbar ist, sowie einen Piezoaktor mit einem derartigen Dichtungselement.

Für die Kraftstoffversorgung von Verbrennungsmotoren werden zunehmend Hochdruck-Speichereinspritzsysteme verwendet. Solche Einspritzsysteme sind als Common-Rail-Systeme (für Dieselmotoren) und HPDI-Einspritzsysteme (für Ottomotoren) bekannt. Bei diesen Einspritzsystemen wird der Kraftstoff mit einer Hochdruckpumpe in einen allen Zylindern des Motors gemeinsamen Druckspeicher gefördert, von dem aus die Einspritzventile an den einzelnen Zylindern versorgt werden. Die Steuerung des Öffnens und Schließens der Einspritzventile kann elektromagnetisch oder elektrisch erfolgen; im vorliegenden Fall werden dazu elektrische Piezoaktoren herangezogen.

Der Piezoaktor wirkt dabei in der Regel auf ein Steuer- oder Servoventil ein, das hydraulisch den Druck steuert, der auf die Düsennadel des Einspritzventils ausgeübt wird. Die Düsennadel des Einspritzventils wird also vom Piezoaktor nicht direkt angesteuert, sondern indirekt über das Steuer- oder Servoventil.

In der deutschen Patentschrift DE 198 44 742 C1 ist eine Kontaktierung für einen in eine Kunststoffhülse eingesetzten Piezoaktor beschrieben, die den Piezoaktor elektrisch mit Anschlussstiften verbindet, an die äußere Zuleitungen angeschlossen werden können. Die Anschlussstifte sind dabei kraft- und/oder formschlüssig in die Kunststoffhülse eingepresst oder eingegossen, und mit den Anschlussstiften ist jeweils eine elektrisch leitende Leiterbahn verbunden, die vom Anschlussstift zu einem der elektrischen Anschlüsse des Piezoaktors führt. Durch die formschlüssige Umspritzung oder kraftschlüssige Einpressung der Anschlussstifte in die Kunststoffhülse wirkt die Kunststoffhülse als feste Einspannung, die die Kräfte an den Anschlussstiften vollständig aufnimmt. Die empfindlichen Kontaktfahnen direkt an den Piezoanschlüssen bleiben ohne Krafteinwirkung.

In der deutschen Patentschrift DE 198 44 743 C1 ist ein Kontaktzungenträger zur Abdichtung und Positionierung von Kontaktstiften beschrieben. Der Kontaktzungenträger weist Bohrungen für die Kontaktstifte auf, an denen Schweißlaschen so angeordnet sind, dass sie mit den Kontaktstiften verschweißt werden können. Am oberen Rand einer Bohrung ist jeweils eine Dichtlippe derart exzentrisch angeordnet, dass der Mittelpunkt des Dichtlippendurchmessers aus der Mitte der Bohrung in Richtung der Schweißlasche verschoben ist. Diese exzentrische Dichtlippe sorgt einerseits durch eine elastische Anlage am Kontaktstift zuverlässig für eine Abdichtung zwischen Kontaktstift und Kontaktzungenträger. Gleichzeitig sichert die Dichtlippe durch ihre exzentrische, zur Schweißlasche hin verschobene Geometrie, dass der Kontaktstift unabhängig von den Fertigungstoleranzen an der Schweißlasche positioniert und an diese angedrückt wird.

Aus der Druckschrift US 5,797,761 ist ein Dichtungselement aus einem Elastomer bekannt, das einen umlaufenden Dichtungswulst und zweite Dichtmittel aufweist, mit dem eine Durchführung abgedichtet ist.

Aus der Druckschrift DE 100 45 706 A1 ist ebenfalls ein Dichtungselement entnehmbar, das einen umlaufenden Dichtungswulst sowie weitere Dichtmittel für einen Kontaktstift aufweist.

Es ist Aufgabe der Erfindung, bei geringem baulichen Aufwand sowohl eine Abdichtung des Piezoaktors gegenüber dem Injektorkörper als auch eine Abdichtung der Kontaktstifte zur Verfügung zu stellen.

Diese Aufgabe wird erfindungsgemäß durch ein Dichtungselement gemäß Anspruch 1 sowie durch einen Piezoaktor gemäß Anspruch 9 gelöst.

Das erfindungsgemäße Dichtungselement ist auf die Kopfplatte eines Piezoaktors für das Kraftstoff-Einspritzventil eines Verbrennungsmotors aufsteckbar, wobei der Piezoaktor zum Einbau in einen Injektorkörper eines Einspritzmotors vorgesehen ist. Das Dichtungselement besteht aus einem Elastomer. An einem ersten Ende des Dichtungselements, mit dem das Dichtungselement in den Injektorkörper einsetzbar ist, ist mindestens ein umlaufender Dichtungswulst angeformt, welcher eine Abdichtung zum Injektorkörper hin bewirkt. Das Dichtungselement weist mindestens eine Durchführung zur Aufnahme von Kontaktstiften auf, welche sich in Längsrichtung durch das Dichtungselement hindurch erstreckt. Die mindestens eine Durchführung ist mittels zweiter Dichtmittel zu den Kontaktstiften hin abgedichtet, wobei die Dichtwirkungen des mindestens einen umlaufenden Dichtungswulsts einerseits und der zweiten Dichtmittel andererseits voneinander entkoppelt sind.

Das erfindungsgemäße Dichtelement für den Piezoaktor eines Einspritzventils erlaubt es, verschiedene Abdichtstellen mit nur einem einzigen, aus Elastomermaterial gefertigten Bauteil zu dichten. Mit Hilfe der um das Dichtelement umlaufenden Dichtungswülste ist es möglich, die Bohrung im Injektorgehäuse, in das der Piezoaktor eingesetzt wird, rund um das Dichtelement abzudichten. Durch diese Verschlussdichtung kann das Innere des Injektorgehäuses, also der Einbauraum für die Aktoren, hermetisch vom Außenraum isoliert werden.

Die elektrischen Anschlüsse für den Piezoaktor werden in Form von Kontaktstiften durch das Dichtungselement hindurch geführt. Hierzu weist das erfindungsgemäße Elastomerbauteil mindestens eine Durchführung auf, in die die Kontaktstifte eingeschoben werden. Dadurch werden die verschiedenen elektrischen Anschlüsse gegeneinander isoliert. Außerdem wird die richtige Positionierung der Anschlüsse gewährleistet, was für eine automatisierte Fertigung sehr wichtig ist.

Um die durch die Durchführungen geschaffene Verbindung zwischen dem Aktorinnenraum und dem Außenraum des Injektorgehäuses gegen Flüssigkeiten verschiedenster Art, Verschmutzungen, etc. abzudichten, ist die mindestens eine Durchführung mittels zweiter Dichtmittel zu den Kontaktstiften hin abgedichtet

Die verschiedenen durch das Bauteil bewirkten Abdichtungen wirken völlig unabhängig voneinander und beeinträchtigen sich gegenseitig nicht. Eine Verformung im Bereich der Dichtungswülste wirkt sich nicht auf die durch die zweiten Dichtmittel bewirkte Abdichtung aus und umgekehrt. Die beiden Dichtfunktionen sind also voneinander entkoppelt, so dass auftretende Verformungen die Dichtheit nicht beeinträchtigen.

Das erfindungsgemäße Elastomerteil lässt sich einfach und kostengünstig herstellen, ermöglicht eine einfache Montage und deckt alle erforderlichen Funktionen ab. Der zur Verfügung stehende Bauraum wird optimal genutzt.

Es ist von Vorteil, wenn es sich bei den zweiten Dichtmitteln um Dichtlippen handelt, welche am ersten Ende des Dichtungselements jeweils um die mindestens eine Durchführung herum angeformt sind.

Bei dieser Ausführungsform der Erfindung sind auf der dem Außenraum zugewandten Seite des erfindungsgemäßen Elastomerteils flexible Dichtlippen vorgesehen, welche die Kontaktstifte manschettenförmig umschließen. Auf diese Weise ist es möglich, die durch die Durchführungen geschaffene Verbindung zwischen dem Aktorinnenraum und dem Außenraum des Injektorgehäuses gegen Flüssigkeiten verschiedenster Art, Verschmutzungen, etc. zuverlässig abzudichten. Die Dichtwirkungen des mindestens einen umlaufenden Dichtungswulsts einerseits und der am ersten Ende des Dichtungselements angeformten Dichtlippen andererseits sind dabei vollständig voneinander entkoppelt: Bei einer Verformung im Bereich des umlaufenden Dichtungswulsts dichten die flexiblen Dichtlippen die Durchführungen für die Kontaktstifte nach wie vor zuverlässig ab. Wenn umgekehrt auf die Kontaktstifte Zwangskräfte einwirken, dann gleichen die Dichtlippen Verschiebungen der Kontaktstifte aus, ohne dass hierdurch die durch den mindestens einen Dichtungswulst bewirkte Abdichtung beeinträchtigt würde.

Gemäß einer vorteilhaften Ausführungsform der Erfindung ist an dem zum ersten Ende entgegengesetzten Ende des Dichtungselements eine Elastomertülle angeformt, wobei das Dichtungselement mittels der Elastomertülle auf die Kopfplatte des Piezoaktors aufsteckbar ist. Beim Einbau des Piezoaktors in die hierfür vorgesehene Aussparung des Injektorgehäuses umschließt die Elastomertülle die Kopfplatte des Piezoaktors und ermöglicht so eine dämpfende und schwingungsabsorbierende Lagerung des Piezoaktors. Dadurch werden insbesondere die empfindlichen Zuleitungen des Piezoaktors geschützt.

Es ist von Vorteil, wenn die Elastomertülle so ausgeformt ist, dass sie beim Aufstecken auf die Kopfplatte des Piezoaktors den Piezoaktor dichtend nach außen abschließt. Mit Hilfe der angeformten Elastomertülle kann das erfindungsgemäße Dichtungselement insofern noch eine dritte Dichtfunktion erfüllen und den Piezoaktor vor Feuchtigkeit, Schmutz, etc. schützen.

Dabei ist es ist von Vorteil, wenn die Innenseite der Elastomertülle als Gegenstück zu einem an der Kopfplatte des Piezoaktors angeformten Absatz ausgebildet ist. Bei der Montage wird das Dichtungselement mit der angeformten Elastomertülle auf den an der Kopfplatte angeformten Absatz aufgesteckt. Dadurch, dass die Tülle als Gegenstück zu dieser Kopfplatte ausgebildet ist, lässt sich eine verbesserte mechanische Fixierung des Piezoaktors erzielen.

Es ist von Vorteil, wenn die Elastomertülle zugleich als Positionierhilfe beim Positionieren des Piezoaktors sowie der Kontaktstifte während des Fügeprozesses dient. Beim Zusammenbau des Piezoaktors werden zunächst die Kontaktstifte durch die Durchführungen des Dichtungselements geschoben und mit jeweils einem der Zuleitungsdrähte elektrisch verbunden. Anschließend wird der Piezoaktor mit seiner Kopfplatte voran in das Dichtungselement eingeschoben; gleichzeitig werden die Kontaktstifte aus dem Dichtungselement herausgezogen und können dann entsprechend gekürzt werden. Daraufhin kann der Piezoaktor mit dem aufgesteckten Dichtungselement in die hierfür vorgesehene Aussparung des Injektorgehäuses eingebaut werden. Insofern dient das Dichtungselement mit der angeformten Elastomertülle als Positionierhilfe beim Einbau des Piezoaktors.

Es ist von Vorteil, wenn die Außenseite der Elastomertülle als Gegenstück zu der zum Einbau des Piezoaktors vorgesehenen Aussparung im Injektorkörper ausgebildet ist und nach dem Einbau in den Injektorkörper formschlüssig an der Aussparung anliegt. Auf diese Weise kann ein stabiler mechanischer Sitz des Piezoaktors im Injektorkörper gewährleistet werden. Außerdem wird sichergestellt, dass der Piezoaktor relativ zum Injektorkörper korrekt positioniert ist.

Gemäß einer vorteilhaften Ausführungsform der Erfindung sind der mindestens eine umlaufende Dichtungswulst einerseits und die zweiten Dichtmittel andererseits zur Entkopplung der Dichtwirkungen quer zur Längsrichtung in verschiedenen Ebenen angeordnet. Dadurch, dass sich die Abdichtstellen in verschiedenen Ebenen befinden, wirken sich Verformungen im Bereich einer Abdichtstelle nicht auf andere Abdichtstellen aus. Eine Verformung des Dichtungselements im Bereich des Dichtungswulsts wirkt sich nicht auf die beispielsweise mittels Dichtlippen realisierte Abdichtung der Kontaktstifte aus. Umgekehrt ist bei einer durch eine Zwangskraft bewirkten Verformung im Bereich der Dichtlippen für die Kontaktstifte gewährleistet, dass die Abdichtung des Piezoaktors gegenüber der Aussparung des Injektorkörpers nicht beeinträchtigt wird.

Gemäß einer weiteren vorteilhaften Ausführungsform der Erfindung ist der mindestens eine umlaufende Dichtungswulst zur Entkopplung der Dichtwirkungen radial beabstandet zu den zweiten Dichtmitteln angeordnet. Auch mittels eines derartigen radialen Abstands kann verhindert werden, dass sich Verformungen im Bereich einer Abdichtstelle auf andere Abdichtstellen auswirken und diese eventuell undicht werden lassen. Im Vergleich zu der oben beschriebenen Ausführungsform der Erfindung, bei der die Abdichtstellen in verschiedenen Ebenen angeordnet sind, kann das Dichtungselement bei dieser Ausführungsform relativ flach ausgeführt werden.

Der erfindungsgemäße Piezoaktor umfasst einen Piezostack sowie ein Dichtungselement der oben beschriebenen Art. Dabei ist es von Vorteil, wenn die Zuleitungen des Piezostack mit Kontaktstiften elektrisch verbunden sind, welche durch die Durchführungen des Dichtungselements geführt werden. Mit Hilfe des Dichtungselements werden die Kontaktstifte mechanisch fixiert. Auf diese Weise wird eine gewisse Zugentlastung für die Zuleitungen des Piezostack geschaffen. Dadurch kann verhindert werden, dass von außen auf die Kontaktstifte einwirkende Kräfte die Zuleitungen des Piezostack beschädigen.

Ein Ausführungsbeispiel der Erfindung wird im folgenden anhand der Zeichnung näher erläutert. Es zeigen:
Fig. 1 die Einbausituation des erfindungsgemäßen Dichtungselements;
Fig. 2 einen Längsschnitt durch das erfindungsgemäße Dichtungselement;
Fig. 3 ein Überblicksbild eines Piezoaktors, bei dem das erfindungsgemäße Dichtungselement zum Einsatz kommt.

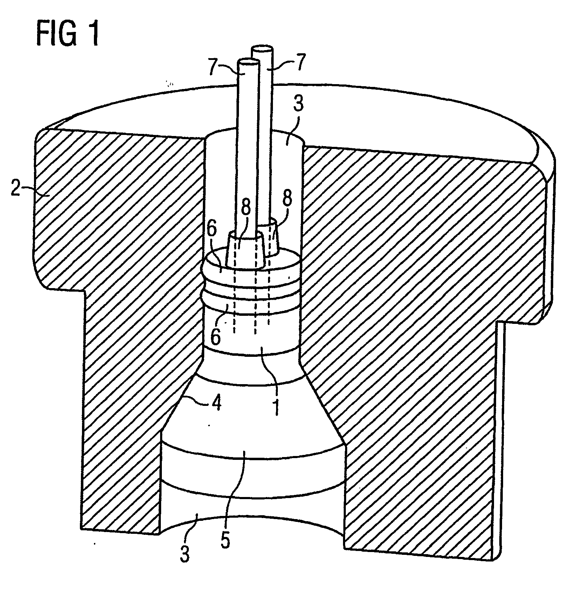

In Fig. 1 ist dargestellt, wie das erfindungsgemäße Dichtungselement 1 in eine hierfür vorgesehene Aussparung 3 des Injektorkörpers 2 eingesetzt ist. Die Aussparung 3 weist an ihrem unteren Ende einen Abschnitt 4 auf, der sich zum Motor hin konisch verbreitert. An das Dichtungselement 1 ist eine Elastomertülle 5 angeformt, die als Gegenstück zu dem Abschnitt 4 ausgebildet ist. Mit Hilfe der Elastomertülle 5 kann das Dichtungselement 1 auf die Kopfplatte des Piezoaktors aufgesteckt werden. Das Dichtungselement 1 wird von unten aus so weit in die Aussparung 3 eingeschoben, bis die Elastomertülle 5 an dem Abschnitt 4 der Aussparung 3 formschlüssig anliegt.

Das Dichtungselement 1 ist vollständig aus Elastomer hergestellt. Am oberen Ende des Dichtungselements 1 sind zwei umlaufende Dichtungswülste 6 angeformt, die beim Einschieben des Dichtungselements in die Aussparung 3 zusammengedrückt werden und dadurch die Aussparung 3 nach außen hin abdichten. Dadurch wird das Innere des Injektorkörpers 2 gegenüber der Umgebung hermetisch abgedichtet. Auf diese Weise wird der Einbauraum für den Piezoaktor vor Umgebungseinflüssen, und insbesondere vor Flüssigkeiten verschiedenster Art geschützt, und dies gewährleistet eine zuverlässige Funktion des Piezoantriebs über die gesamte Fahrzeuglebensdauer hinweg.

Das Dichtungselement 1 besitzt zwei in Längsrichtung verlaufende Durchführungen. Diese Durchführungen dienen zur Aufnahme der Kontaktstifte 7, die mit den elektrischen Zuleitungen des Piezoaktors verbunden sind. Über die Kontaktstifte 7 wird eine Steuerspannung an den Piezoaktor angelegt. Am oberen Ende des Dichtungselements 1 sind um jede der Durchführungen herum flexible Dichtlippen 8 angeformt, welche die eingeschobenen Kontaktstifte 7 dichtend umschließen. Auf diese Weise ist gewährleistet, dass keine Flüssigkeit von außen in das Innere des Piezoaktors eindringen kann.

Bei dem erfindungsgemäßen Dichtungselement 1 ist die durch die umlaufenden Dichtungswülste 6 bewirkte Dichtfunktion vollständig von der durch die flexiblen Dichtlippen 8 bewirkten Dichtfunktion entkoppelt. Dadurch wirkt sich eine Verformung im Bereich der umlaufenden Dichtungswülste 6, die durch die Verpressung auftritt, nicht auf die Dichtwirkung der flexiblen Dichtlippen 8 aus. Umgekehrt kann eine eventuelle Zwangslage der Kontaktstifte 7 durch die Flexibilität der Dichtlippen 8 ausgeglichen werden, ohne dass hierdurch die Wirkung der Dichtungswülste 6 beeinträchtigt würde. Relativ-bewegungen, die durch Wärmeausdehnung und Vibrationen entstehen, können durch das Elastomermaterial ausgeglichen und gedämpft werden.

Um zu gewährleisten, dass die Dichtfunktionen voneinander entkoppelt sind und sich nicht gegenseitig beeinträchtigen, muss zwischen den verschiedenen Dichtungen genügend Elastomermaterial vorhanden sein, welches eine Pufferfunktion erfüllt. Im dargestellten Ausführungsbeispiel werden die verschiedenen durch das Dichtungselement 1 realisierten Dichtungsfunktionen dadurch voneinander entkoppelt, dass sich die Dichtungswülste 6 und die Dichtlippen 8 in verschiedenen Ebenen quer zur Längsrichtung des Dichtungselements 1 befinden.

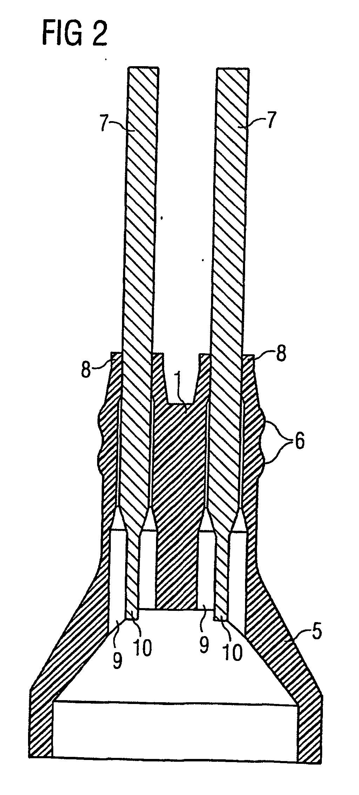

Fig. 2 zeigt einen Querschnitt durch das Dichtungselement 1, anhand dessen sich die verschiedenen mittels des Dichtelements 1 realisierten Dichtwirkungen erkennen lassen. Die umlaufenden Elastomerwülste 6 sorgen für eine Abdichtung des Dichtungselements 1 gegenüber der zugehörigen Aussparung des Injektorkörpers. Die Durchführungen 9, welche sich in Längsrichtung durch das Dichtungselement 1 erstrecken, dienen zur Aufnahme der beiden Kontaktstifte 7. Die Dichtlippen 8 dienen dazu, die Kontaktstifte 7 gegenüber dem Piezoaktor abzudichten. Die Zuleitungen des Piezoaktors können an den Abflachungen 10 angeschweißt oder in sonstiger Weise elektrisch verbunden werden. Am unteren Ende des Dichtungselements 1 ist die Elastomertülle 5 angeformt, mit der das Dichtungselement 1 auf die Kopfplatte des Piezoaktors aufgesteckt wird.

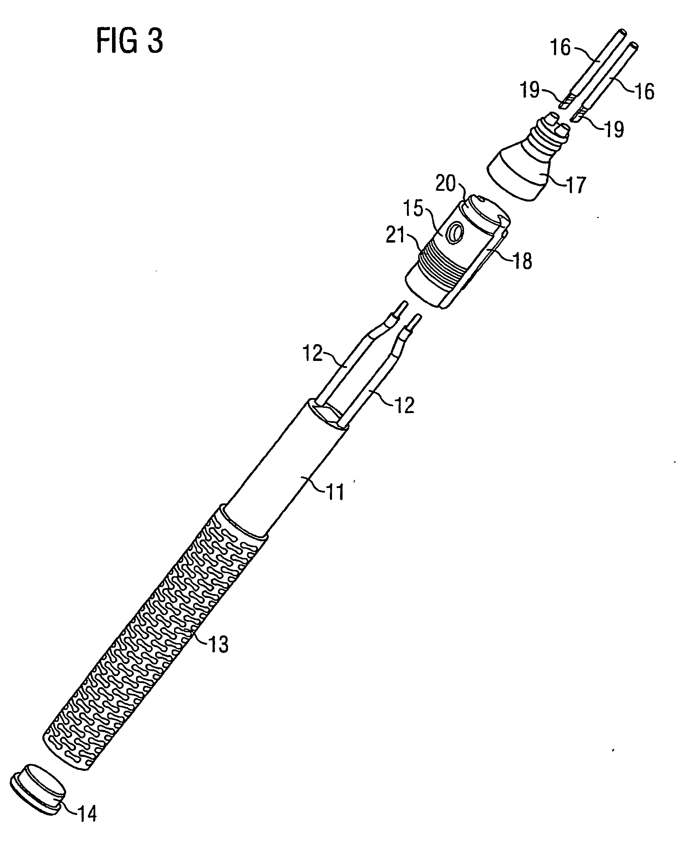

Fig. 3 zeigt den gesamten Aufbau des Piezoaktors im Überblick. Der Piezostack 11 kann durch Anlegen eines Spannungssignals an die Zuleitungen 12 in Längsrichtung verformt werden. Der Piezostack 11 befindet sich innerhalb der Rohrfeder 13, die mit der Bodenplatte 14 verschweißt ist. Die Rohrfeder 13 ist mit der Kopfplatte 15 so verbunden, dass sie unter einer gewissen Vorspannung steht, welche als Rückstellkraft für den Piezostack 11 wirkt.

Zur Montage des Piezoaktors werden die Kontaktstifte 16 durch die Durchführungen des Dichtungselements 17 und durch die seitlichen Schlitze 18 der Kopfplatte 15 geschoben. Die Abflachungen 19 werden mit den Zuleitungen 12 elektrisch leitend verbunden, beispielsweise verschweißt. Als Schweißtechniken kommen hierbei insbesondere Laserstrahl-, Lichtbogen- oder Widerstandsschweißen in Betracht. Anschließend wird das Dichtungselement 17 zur Kopfplatte 15 hin verschoben; dabei werden die Kontaktstifte 16 aus dem Dichtungselement 17 herausgezogen. Das Dichtungselement 17 wird auf den angeformten Absatz 20 aufgesteckt. Damit sind der Piezostack 11, die Kopfplatte 15 und das Dichtungselement 17 relativ zueinander positioniert. Die Kontaktstifte 16 können nun auf die gewünschte Länge gekürzt werden.

Anschließend wird der zusammengebaute Piezoaktor in die entsprechende Aussparung im Injektorkörper eingesetzt und in der gewünschten Position fixiert. Dies kann beispielsweise dadurch erfolgen, dass der Piezoaktor gegenüber dem Injektorkörper mit Hilfe von Verstemmungselementen verstemmt wird. Dabei dient das Gewinde 21 zur Fixierung der Verstemmungselemente.

## Patentansprüche

1. Dichtungselement (1, 17), welches auf die Kopfplatte (15) eines Piezoaktors für das Kraftstoff-Einspritzventil eines Verbrennungsmotors aufsteckbar ist, wobei der Piezoaktor zum Einbau in einen Injektorkörper (2) eines Einspritzmotors vorgesehen ist, wobei:
- das Dichtungselement (1, 17) Elastomer aufweist,
- an einem ersten Ende des Dichtungselements (1, 17), mit dem das Dichtungselement (1, 17) in den Injektorkörper (2) einsetzbar ist, mindestens ein umlaufender Dichtungswulst (6) angeformt ist, welcher eine Abdichtung zum Injektorkörper (2) hin bewirkt,
- das Dichtungselement (1, 17) mindestens eine Durchführung (9) zur Aufnahme eines Kontaktstiftes (7, 16) aufweist, der sich in Längsrichtung durch das Dichtungselement (1, 17) hindurch erstreckt, wobei die mindestens eine Durchführung (9) mittels zweiter Dichtmittel zu dem Kontaktstift (7, 16) hin abgedichtet ist,
- die Dichtwirkungen des mindestens einen umlaufenden Dichtungswulsts (6) einerseits und der zweiten Dichtmittel andererseits voneinander entkoppelt sind,
**dadurch gekennzeichnet, dass**
- an dem zum ersten Ende entgegengesetzten Ende des Dichtungselements eine Elastomertülle (5) angeformt ist, wobei das Dichtungselement (1, 17) mittels der Elastomertülle (5) auf die Kopfplatte (15) des Piezoaktors aufsteckbar ist.

2. Dichtungselement nach Anspruch 1, **dadurch gekennzeichnet, dass** es sich bei den zweiten Dichtmitteln um Dichtlippen (8) handelt, welche am ersten Ende des Dichtungselements jeweils um die mindestens eine Durchführung (9) herum angeformt sind.

3. Dichtungselement nach Anspruch 1, **dadurch gekennzeichnet, dass** die Elastomertülle (5) so ausgeformt ist, dass sie beim Aufstecken auf die Kopfplatte (15) des Piezoaktors den Piezoaktor dichtend nach außen abschließt.

4. Dichtungselement nach einem der Ansprüche 1 bis 3, **dadurch gekennzeichnet, dass** die Innenseite der Elastomertülle (5) als Gegenstück zu einem an der Kopfplatte (15) des Piezoaktors angeformten Absatz (20) ausgebildet ist.

5. Dichtungselement nach einem der Ansprüche 1 bis 4, **dadurch gekennzeichnet, dass** die Elastomertülle (5) zugleich als Positionierhilfe beim Positionieren des Piezoaktors sowie der Kontaktstifte (7, 16) während des Fügeprozesses dient.

6. Dichtungselement nach einem der Ansprüche 1 bis 5, **dadurch gekennzeichnet, dass** die Außenseite der Elastomertülle (5) als Gegenstück zu der zum Einbau des Piezoaktors vorgesehenen Aussparung (3) im Injektorkörper (2) ausgebildet ist und nach dem Einbau in den Injektorkörper (2) formschlüssig an der Aussparung (3) anliegt.

7. Dichtungselement nach einem der Ansprüche 1 bis 6, **dadurch gekennzeichnet, dass** der mindestens eine umlaufende Dichtungswulst (6) einerseits und die zweiten Dichtmittel andererseits zur Entkopplung der Dichtwirkungen quer zur Längsrichtung in verschiedenen Ebenen angeordnet sind.

8. Dichtungselement nach einem der Ansprüche 1 bis 7, **dadurch gekennzeichnet, dass** der mindestens eine umlaufende Dichtungswulst (6) zur Entkopplung der Dichtwirkungen radial beabstandet zu den zweiten Dichtmitteln angeordnet ist.

9. Piezoaktor, welcher einen Piezostack (11) sowie ein Dichtungselement (1, 17) nach einem der Ansprüche 1 bis 8 umfasst.

10. Piezoaktor nach Anspruch 9, **dadurch gekennzeichnet, dass** die Zuleitungen (12) des Piezostack (11) mit Kontaktstiften (7, 16) elektrisch verbunden sind, welche durch die mindestens eine Durchführung (9) des Dichtungselements (1, 17) geführt werden.

## Claims

1. Sealing element (1, 17) that can be plugged onto the head plate (15) of a piezo actuator for a fuel injection valve of an internal-combustion engine, in which case the piezo actuator is provided to be fitted in the injector body (2) of an injection engine,
in which;
- the sealing element (1, 17) consists of an elastomer,
- at least one encircling sealing bead (6) is formed on the first end of the sealing element (1, 17) by means of which the sealing element (1, 17) can be inserted into the injector body (2) and seals it off from the injector body (2),
- the sealing element (1, 17) has at least one breakthrough (9) for accommodating contact pins (7, 16) which pass through the sealing element (1, 17) in a longitudinal direction, in which case the at least one breakthrough (9) is sealed by means of a second sealing means to the contact pins (7, 16), and
- the sealing effects of at least one encircling sealing bead (6), on the one hand, and the second sealing means, on the other hand, are decoupled from one another, **characterised in that**
an elastomer grommet (5) is formed at the end of the sealing element opposing the first end, in which the sealing element (1, 17) can be plugged onto the head plate (15) of the piezo actuator by means of the elastomer grommet (5).

2. Sealing element according to claim 1, **characterised in that** the second sealing means are sealing lips (8), which in each case are formed around at the least one breakthrough (9) on the first end of the sealing element.

3. Sealing element according to claim 1, **characterised in that** an elastomer grommet (5) is formed in such a way that when it is plugged onto the head plate (15) of the piezo actuator, it completely seals the piezo actuator on the outside.

4. Sealing element according to claim 1 or 3, **characterised in that** the inside of the elastomer grommet (5) is embodied as a counterpart to a spigot (20) formed on the head plate (15) of the piezo actuator.

5. Sealing element according to one of the claims 1 to 4, **characterised in that** the elastomer grommet (5) at the same time serves as a positioning means when positioning the piezo actuator as well as the contact pins (7, 16) during the joining process.

6. Sealing element according to one of the claims 1 to 5, **characterised in that** the outside of the elastomer grommet (5) is embodied as a counterpart to the recess (3) in the injector body (2) provided to mount the piezo actuator and after it has been mounted in the injector body (2) it fits tightly into the recess (3).

7. Sealing element according to one of the claims 1 to 6, **characterised in that** at least one encircling sealing bead (6), on the one hand, and the second sealing means, on the other hand, are arranged at different levels transverse to the longitudinal direction to separate the sealing efficiencies.

8. Sealing element according to one of the claims 1 to 7, **characterised in that** at least one encircling sealing bead (6) for separating the sealing efficiency is arranged at a radial distance to the second sealing means.

9. Piezo actuator that contains both a piezo stack (11) and a sealing element (1, 17) according to one of the claims 1 to 8.

10. Piezo actuator according to claim 9, **characterised in that** the leads (12) of the piezo stack (11) are connected to the contact pins (7, 16) in an electrically conductive way that pass through at least one breakthrough (9) of the sealing element (1, 17).

## Revendications

1. Elément d'étanchéité (1, 17) qui peut être connecté sur la plaque supérieure (15) d'un actionneur piézoélectrique destiné à la soupape injectrice de carburant d'un moteur à combustion interne, l'actionneur piézoélectrique étant prévu pour être monté dans un corps d'injecteur (2) d'un moteur à injection,
- l'élément d'étanchéité (1, 17) présentant de l'élastomère,
- au moins un bourrelet d'étanchéité circonférentiel (6) qui assure une étanchéification par rapport au corps d'injecteur (2) étant formé sur une première extrémité de l'élément d'étanchéité (1, 17), à l'aide de laquelle l'élément d'étanchéité (1, 17) peut être inséré dans le corps d'injecteur (2),
- l'élément d'étanchéité (1, 17) présentant au moins une traversée (9) destinée à recevoir une broche de contact (7, 16) qui s'étend en sens longitudinal à travers l'élément d'étanchéité (1, 17), la traversée (9) - dont il existe au moins une - étant rendue étanche par rapport à la broche de contact (7, 16) grâce à des deuxièmes moyens d'étanchéité,
- l'effet d'étanchéification du bourrelet d'étanchéité circonférentiel (6) - dont il existe au moins un -, d'une part, et celui des deuxièmes moyens d'étanchéité, d'autre part, étant non-interactifs entre eux,
**caractérisé en ce que**
- sur l'extrémité de l'élément d'étanchéité opposée à la première extrémité est formée une douille en élastomère (5), l'élément d'étanchéité (1, 17) pouvant être enfilé sur la plaque supérieure (15) de l'actionneur piézoélectrique au moyen de la douille en élastomère (5).

2. Elément d'étanchéité selon la revendication 1, **caractérisé en ce que** les deuxièmes moyens d'étanchéité sont des lèvres d'étanchéité (8) formées sur la première extrémité de l'élément d'étanchéité, tout autour de la traversée (9) - dont il existe au moins une.

3. Elément d'étanchéité selon la revendication 1, **caractérisé en ce que** la douille en élastomère (5) est formée de sorte à rendre étanche l'actionneur piézoélectrique vers l'extérieur lorsqu'elle est enfilée sur la plaque supérieure (15) dudit actionneur piézoélectrique.

4. Elément d'étanchéité selon l'une des revendications 1 à 3, **caractérisé en ce que** la face intérieure de la douille en élastomère (5) est réalisée comme pendant d'une saillie (20) formée sur la plaque supérieure (15) de l'actionneur piézoélectrique.

5. Elément d'étanchéité selon l'une des revendications 1 à 4, **caractérisé en ce que** la douille en élastomère (5) sert en outre, pendant le processus d'assemblage, au bon positionnement et de l'actionneur piézoélectrique et des broches de contact (7, 16).

6. Elément d'étanchéité selon l'une des revendications 1 à 5, **caractérisé en ce que** la face extérieure de la douille en élastomère (5) est réalisée comme pendant de l'évidement (3) prévu dans le corps d'injecteur (2) en vue du montage de l'actionneur piézoélectrique et repose, après le montage dans le corps d'injecteur (2), par conjugaison de forme contre l'évidement (3).

7. Elément d'étanchéité selon l'une des revendications 1 à 6, **caractérisé en ce que** le bourrelet d'étanchéité circonférentiel (6) - dont il existe au moins un -, d'une part, et les deuxièmes moyens d'étanchéité, d'autre part, sont disposés dans différents plans, transversalement au sens longitudinal, afin de rendre les effets d'étanchéification non-interactifs entre eux.

8. Elément d'étanchéité selon l'une des revendications 1 à 7, **caractérisé en ce que** le bourrelet d'étanchéité circonférentiel (6) - dont il existe au moins un - est disposé à une distance radiale donnée des deuxièmes moyens d'étanchéité, afin de rendre les effets d'étanchéification non-interactifs entre eux.

9. Actionneur piézoélectrique comprenant une pile piézoélectrique (11) ainsi qu'un élément d'étanchéité (1, 17) selon l'une des revendications 1 à 8.

10. Actionneur piézoélectrique selon la revendication 9, **caractérisé en ce que** les lignes d'alimentation (12) de la pile piézoélectrique (11) sont connectées électriquement aux broches de contact (7, 16) que l'on fait passer à travers la traversée (9) - dont il existe au moins une - de l'élément d'étanchéité (1, 17).
